# EUROPEAN PATENT SPECIFICATION

(11) **EP 1 461 631 B1**
(45) Date of publication and mention of the grant of the patent: **06.06.2007**
(21) Application number: 02790605.6
(22) Date of filing: 17.12.2002
(51) Int. Cl.: G09G 3/32

(54) **A METHOD OF AND AN APPARATUS FOR HEALING OF LOW-OHMIC DEFECTS IN A FLAT DISPLAY PANELS**
VERFAHREN UND VORRICHTUNG ZUR HEILUNG VON NIEDEROHMIGEN FEHLERN IN FLACHBILDSCHIRMEN
PROCEDE ET DISPOSITIF DE REMEDIER A DES DEFAUTS DE FAIBLE RESISTIVITE DANS UN ECRAN PLAT

(30) Priority: 19.12.2001 EP 01130166
(43) Date of publication of application: 29.09.2004
(73) Proprietor: Koninklijke Philips Electronics N.V., 5621 BA Eindhoven (NL); Philips Corporate Intellectual Property GmbH, 20099 Hamburg (DE)
(72) Inventor: GREUEL, Georg, NL-5656 AA Eindhoven (NL); KLEIN, Markus, H., NL-5656 AA Eindhoven (NL); VAN DE WEIJER, Peter, NL-5656 AA Eindhoven (NL); JACOBS, Boudewijn, J., C., NL-5656 AA Eindhoven (NL); GEURTS, Joep, NL-5656 AA Eindhoven (NL)
(74) Representative: Volmer, Georg
(86) International application number: PCT/IB2002/005564
(87) International publication number: WO 2003/052446

(56) References cited:
- WO-A-01/56000
- US-A1- 2002 181 276

## Description

The invention relates to a method of healing low-ohmic defects in a flat display.

"Low-ohmic" means that a leakage current caused by the defect affects the visual performance of the display for human eye.

A flat display is a stacked arrangement of structured layers comprising at least one transparent electrode layer, a light-emitting or light-absorbing or polarizable layer or any other kind of light modulating layer and a counterelectrode layer. One or all electrode layers and the light modulating layer are structured to allow individual addressing of subareas of the display, typically by means of switched driving of the subareas. In a matrix-type display, this subarea consists of a single pixel, whereas in segmented displays, each segment defines a subarea.

Self-emitting passive segmented or matrix displays based on light-emitting polymers have come into the market several years ago. Such displays make use of the phenomenon of electroluminescence, which originates from an organic material comprising, for example, a luminescent compound. This organic layer is sandwiched between two electrodes which are in contact with the organic layer. By applying a suitable voltage, the negative electrode, i.e. the cathode, will inject electrons, and the positive electrode, i.e. the anode, will inject holes. The recombination of these electrons and holes may generate light. When biased in opposite (reversed) direction, current flow is reduced to a residual leakage level, thus generating a diode-like current-voltage characteristic. This type of displays is also referred to as (polymer) light-emitting diode (LED) display. Deposition of the light-emitting organic layer can be done either by non-vacuum wet-chemical processes like spin-coating or printing, or by vacuum deposition technologies like evaporation or chemical vapor deposition. Non-vacuum processes make us of organic materials of high molecular mass compared to the vacuum deposition processes. To differentiate between both types of display, the non-vacuum variant is typically named Polymer LED display (PLED), whereas the vacuum variant is typically named Organic LED (OLED) type display.

In passive matrix driving schemes, one electrode layer is connected to a cathode (e. g. line) driver, and the second electrode layer is connected to the anode (e. g. column) driver. The display information is updated with a given frame rate. By time-multiplexed switching of either anodes or cathodes with a given multiplex rate (typically equal to the number of anodes or cathodes of the display), each anode or cathode is addressed for a maximum time interval of 1/[(multiplex rate) times (frame rate)], typically referred to as line time. In active matrix driving schemes, an arrangement of addressable semiconductor switches is placed close to each display subarea. Refresh of the switching position is done with the given frame rate. Time-mulitplexing of the driving anode or cathode lines is not required. The available line time thus becomes less or equal than 1/[frame rate]. Refresh of the display information is done by programming of the data and address lines of each display subarea.

Common to all displays is a severe lifetime problem, generated by sudden or gradual increase in leakage current through the light modulating layer. This insulation resistance failure is generated by defects or structural inhomogeneities, for example by particles adhering on a substrate, particle contamination during processing of the display or particles coming from the packaging process or materials. Structural inhomogeneities are for example pinholes or hillocks in the layers. Screening or bum-in procedures are no guarantee against the activation of these defects during lifetime.

A reliable display having good visual performance must have small leakage currents. Small means that the luminance and contrast are not affected by parasitic current flow through local defects. For example, a subarea of a light-emitting passive driven display exhibiting increased leakage current will emit less or even no light. Further, there may be extra light in the shorted anode or cathode. Damage may propagate in the active part of the cell, due to overstressing of other parts of the display. Finally, there is a risk of total failure due to overloading of the driver electronics and the interconnections between electronics and display.

Defects can never be excluded. Therefore, the lifetime of a display may drop below the intrinsic lifetime of the light-emitting layer. To avoid this, it is known to passivate a local defect, either by using special gas fillings in the cavity of the display, or by application of extra layers, for example on top of the cathode layer. WO 01/56000 discloses an apparatus for healing low ohmic defects in a flat display, having sub-pixels with special fuses to be burnt by extra current. Other measures are aiming at an improved selection procedure in the outgoing inspection of finished products, for example as disclosed in WO 01/22504.

It is the object of the present invention to provide a method of healing low ohmic-defects in a flat display by utilizing the built-in self-healing properties of the layer stack.

This object is solved by passing an extra current during a predetermined time period through the affected subarea of the flat display, said current being selected to turn at least one defect into a high-ohmic state which has a resistance higher than the initial resistance of said at least one defect.

"Extra current" means that it is a current different from that of normal operation. Specifically, the extra current may be a reverse current.

In particular, "high-ohmic" means that leakage currents can be neglected and the healed defect does no longer affect the visual performance of the display for human eye. For organic or polymer light-emitting diode display, the high-ohmic state is characterized in that the relation I(-V) << I(+V) holds, +V being the polarity of light emission, for all voltages relevant for display driving.

For an organic or polymer LED display, the invention is based on fusing off the defect by exposure of the display or part of the display to a defined electrical stress in reversed direction of a bad pixel or segment. This current must stay within certain boundaries in order to avoid destruction of the display. When the defect is fused, it is switched back into a high-ohmic state by this electrical overstress.

In a preferred embodiment, said current is gradually increased from a starting value to a maximum value.

Said predetermined time period may be a fraction of the line time of said display or a complete line time or frame time.

Said display is an organic or polymer light emitting diode display.

In a passively driven display, the healing current may be generated by connecting one or several anode or cathode lines to either ground or supply voltage by means of the attached anode or cathode drivers, thus maximizing the potential difference or current flow through the affected subarea. In an actively driven display, the supply voltage line is either switched to opposite polarity, or the ground and supply voltage lines are exchanged by means of a switch. The semiconductor switches used to drive the pixels must be designed as a bi-directional switch.

In case of an organic or polymer LED display, the healing current is advantageously flowing in reversed direction of the diode.

The healing current can be adjusted by means of changing the analog supply voltage in amplitude and polarity, by means of parallel switching or shorting of anodes or cathodes, or by means of adaption of the output impedance of the analog driving electronics. This allows for an impedance matching between resistance of said at least one defect and effective output resistance of the analog driving circuit, to maximize or adjust the power dissipation at the defect site, enabling efficient healing of a single defect or several defects.

The method according to the invention is advantageously applied to a passively driven display with programmable drivers for each anode and cathode line of the display, or to an actively driven display with programmable address and data lines.

An apparatus for healing low-ohmic defects according to claim 10 comprises means for providing an extra current selected by control means to turn at least one defect into a high-ohmic state which has a resistance higher than the initial resistance of said at least one defect and means for passing said extra current during a predetermined time period through the affected sub-area of the flat display. Said predetermined time period may also be set by said control means.

Preferably, said apparatus includes means for lowering the effective electrode resistance of the display by parallel switching or shorting of anodes or cathodes.

If a driver for each line or cathode and column or anode of the display is provided, the apparatus may include means for connecting one or several of said column drivers or anode drivers or said line drivers or cathode drivers to either ground or supply voltage.

In an application to actively driven matrix displays, means for changing the potential of the analogue supply voltage line or both analogue supply and ground voltage line may be provided.

Also, the apparatus may include means for adapting the output impedance of at least one of said drivers or the output impedance of the analogue supply or voltage.

In the following, these and other aspects of the invention are further explained with reference to the drawings, wherein
Fig. 1 shows an equivalent circuit for a passively driven matrix display comprising light emitting diodes including anode driver and cathode driver; the pixel connected to anode a2 and cathode c2 is affected by a defect of resistance Rd
Fig. 2 shows an equivalent circuit similar to Fig. 1, wherein a switch is added to the output of the anode driver;
Fig. 3 shows an equivalent circuit similar to Fig. 1, wherein a different cathode driver scheme is used;
Fig. 4 shows an equivalent circuit similar to Fig. 1, including sensing electronics to detect a defect inside a display;
Fig. 5 shows an equivalent circuit similar to Fig. 1 for controlled defect healing;
Fig. 6 shows an equivalent circuit for an actively driven matrix display comprising light emitting diodes including data line and address line, and
Fig. 7 shows an equivalent circuit similar to Fig. 6, wherein the polarity of the supply voltage and ground line has been exchanged.

The invention is exemplarily illustrated with reference to organic or polymer light emitting diode displays.

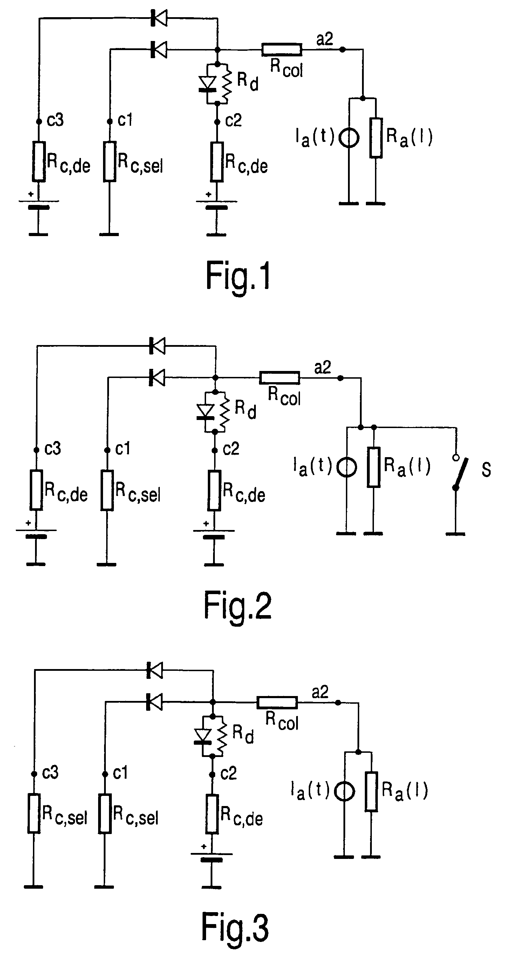

Figure 1 shows an equivalent circuit for a part of a matrix display built up with light emitting diodes, where anode driver and cathode driver are included. The anode driver is usually designed as a constant current source, with a current-dependent output characteristic Rₐ(I). R_{col} is the internal resistance of the cell, connecting the defect to the anode driver. The defect itself is characterized by resistance R_{d}. In this embodiment, cathode c1 is selected, whereas cathode c2 and c3 are deselected. The corresponding cathode driver output characteristic is determined by the resistance R_{c}, sel and R_{c de}. Assuming a multiplexed driving in common cathode mode the following ways are possible to supply the required healing energy by making use of the cathode driver:
1. Force the anode potential al to ground for a minimum time period tₘᵢₙ. The required time can be taken as a fraction of the usual line time of the display; if necessary, the anode can be forced to ground for a complete line time. For coupling to ground, a current-dependent anode output characteristic can be used, so that Rₐ(I)= 0 if Iₐ = 0.
   An alternative of coupling to ground is provided in Figure 2, where a switch S is connected in parallel to the anode driver to shortcut it when the switch S is closed.
2. More than only one cathode can be switched to ground. Instead, two cathodes can be switched to ground or even all cathodes except one. There is the advantage that the healing current is sinked by the grounded cathode drivers. This driving mode shall be referred to as "inversed multiplex" driving mode in the following. The scheme, where two neighboured cathodes c3 and c1 are selected is illustrated in Figure 3.
3. With a given driver output impedance, the power dissipated in the defect R_{d} is maximized by means of impedance matching, i.e. when R_{d} is equal to the overall output impedance of the electrical surrounding. If inverse multiplexing is used for fusing the defect, this condition requires that R_{c}, de must be approximately equal to R_{d}. To cover a largest-possible range of defects, a very low-ohmic cathode driver output can be used. The resistance values R_{c}, _{de} and R_{c}, ₛₑₗ implemented in the cathode driver must be related to the maximum acceptable healing power of the cell and the frequency of shorting. Otherwise, there is the risk of generating black spots inside the display, if the healing is based of evaporation of the cathode layer around the defect.

A combination of the measures under 1. to 3. can be taken to heal a defect in a light emitting diode display.

A method of improving lifetime of a passively or actively driven display by applying the method according to the invention may use three different strategies.

In a first strategy, referred to as "forced defect healing", one of the above measures 1. to 3. is taken at a predetermined time or regularly in certain time intervals. A predetermined time may be the time of powering up the display, leaving the stand-by modus or the like. Suitable time intervals can be periods of every n-frames, where n is an integer. The healing method must be applied to the whole display, since in this situation the location of the defect is not known.

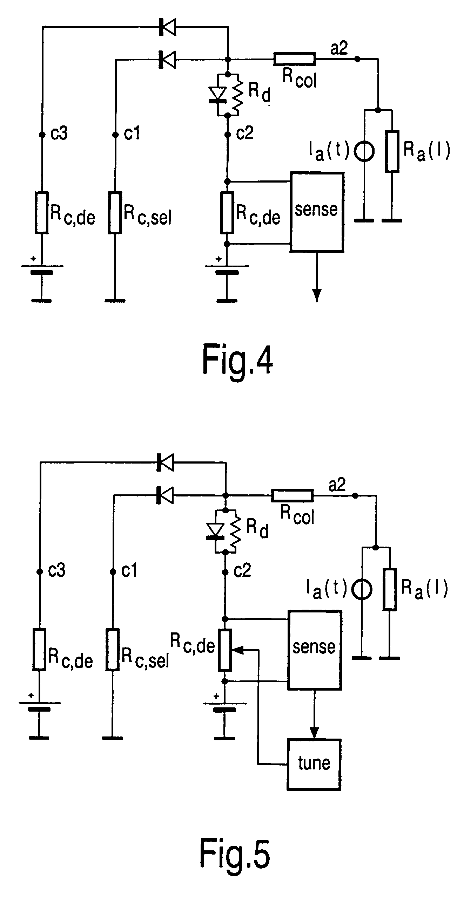

Figure 4 illustrates a second strategy, named "sensed defect healing", wherein sensing electronics is used to detect a defect inside the display, in the embodiment by monitoring of the voltage drop across the resistor of the deselected cathode driver. If the voltage exceeds a given limit value, a healing cycle is activated by means of the output line of the sense circuit. This means that the cathode driver must be extended by a defect detection circuit. Additional or alternative sensing circuits can be applied to the anode driver or to the select resistor of the cathode driver. The latter requires that the anode potential is forced to zero during sensing. Sensed defect removal has the advantage that the healing cycle is only applied if required, and that the cycle can be restricted to the affected part of the display, e.g. to the single line showing increased leakage.

If sensed defect healing is applied, it is feasible to change the output characteristic of the cathode driver depending on the defect resistance level. If the defect healing was not successful, the output resistance can be changed, for example by using a tuneable resistor in the output line of the cathode driver, as shown in Figure 5. The strategy is therefore named "controlled defect healing".

The embodiments have been explained with a display driver concept based on multiplexing in line direction which usually means cathode direction. However, the proposed measures are also suitable for multiplexing in column direction, which is usually anode direction.

The invention uses the source and sink capabilities of cathode and/or anode driver for the healing energy supplied to the defect to heal the defect with an optimum amount of energy.

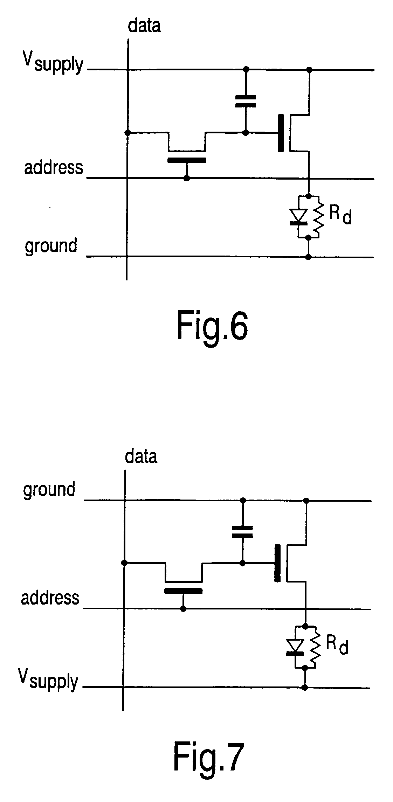

In actively driven circuits, the healing methods can be applied in an analog way. Figure 6 shows an equivalent circuit for a single pixel of an active matrix display. The light generating current of an organic or polymer light emitting diode display is sourced by a supply voltage line, flowing through a semiconductor switch which is conductive for a certain amount of time, provided that the pixel has been addressed by data and address lines. The storage capacitor preserves the potential of the switch capacitor gate until the next frame is programmed.

To heal defects by means of reversed current flow, the potential of the analog supply voltage line can be changed from positive to negative against ground, or the ground and analog supply voltages can be exchanged during the healing cycle, as shown in Figure 7.

Sensing of defects is possible in actively driven matrix displays by monitoring of current level on analog supply or ground lines during a period where the pixel luminance is programmed to zero.

Controlled defect healing can be achieved by adapting the output impedance of the analog supply voltage, or by adjusting the amplitude of the analog supply voltage during a healing cycle.

As an alternative, the on-resistance (resistance of a switch in the conductive state) of the semiconductor switch (or switches) used to drive the pixel can be adjusted by means of adjusting appropriate voltages at the data line and the address line.

## Claims

1. A method of healing low-ohmic defects in a flat display, being an organic or polymer light emitting diode display, **characterized by** passing an extra current, which is a current different from that of normal operation, during a predetermined time period through the affected subarea of the flat display, said current being selected to turn at least one defect into a high-ohmic stat, which has a resistance higher than the initial resistance of said at least one defect.

2. The method of claim 1, **characterized by** gradually increasing said current from a starting value to a maximum value.

3. The method of claim 1, **characterized in that** said predetermined time period is a function of a line time or frame time of said display.

4. The method of claim 1, **characterized in that** said healing current is generated by the connected driver circuit by lowering the effective electrode resistance of the display by means of parallel switching or shorting of anodes or cathodes.

5. The method of any of claims 1 to 4 with a driver for each line or cathode and column or anode of the display, **characterized in that** said current is generated by connecting one or several of said column drivers or anode drivers or said line drivers or cathode drivers to either ground or supply voltage, thus maximizing the potential difference across or the current passing through the affected pixel.

6. The method of claim 1 to 4 applied to actively driven matrix displays by changing the potential of the analog supply voltage line or both analog supply and ground voltage line or by adjusting the on-resistance of a semiconductor switch used to drive a pixel by means of adjusting appropriate data line and address line voltages.

7. The method of claim 5 and 6, **characterized by** adapting the output impedance of at least one of the said drivers or the output impedance of the analog supply voltage.

8. A method of improving lifetime of a passively or actively driven display by applying the methods of claim 1 to 7 at selected times.

9. The method of claim 8, **characterized by** measuring the leakage current of the display or part of the display before applying the method of any of the claims 1 to 7.

10. A flat display, being an organic or polymer light emitting diode display,
with an apparatus for healing low-ohmic defects in said display comprising means for providing an extra current, which is a current different from that of normal operation, to turn at least one defect into a high-ohmic state which has a resistance higher than the initial resistance of said at least one defect,
control means for selecting said means for providing an extra current, and means for passing said extra current during a predetermined time period through the affected sub-area of the flat display,
**characterized in that** said display and apparatus are arranged to carry out the method according to claim 1.

11. The apparatus of claim 10, wherein said control means is arranged to set said predetermined time period.

12. The apparatus of claim 10, **characterized by** means for lowering the effective electrode resistance of the display by means of parallel switching or shorting of anodes or cathodes.

13. The apparatus of claim 10, for use with a driver for each line or cathode and column or anode of the display, **characterized by** means (S) for connecting one or several of said column drivers or anode drivers or said line drivers or cathode drivers to either ground or supply voltage.

14. The apparatus of claim 10, **characterized by** means for changing the potential of the analogue supply voltage line or both analogue supply and ground voltage line in an actively driven matrix display.

15. The apparatus of claim 10, **characterized by** means for adapting the output impedance of at least one of said drivers or the output impedance of the analogue supply voltage.

## Patentansprüche

1. Verfahren zur Heilung von niederohmigen Fehlern in einem Flachbildschirm, einem Organischen oder Polymer-Leuchtdioden-Display, **dadurch gekennzeichnet, dass** während eines vorgegebenen Zeitraums durch den beeinträchtigten Teilbereich des Flachbildschirms ein Extrastrom geleitet wird, wobei der Strom so gewählt wird, dass er mindestens einen Fehler in einen hochohmigen Zustand versetzt, welcher einen höheren Widerstand als der Ausgangswiderstand des mindestens einen Fehlers aufweist.

2. Verfahren nach Anspruch 1, **dadurch gekennzeichnet, dass** der Strom allmählich von einem Ausgangswert auf einen Maximalwert erhöht wird.

3. Verfahren nach Anspruch 1, **dadurch gekennzeichnet, dass** die vorgegebene Zeitperiode eine Funktion einer Zeilendauer oder Frame-Zeit des Displays darstellt.

4. Verfahren nach Anspruch 1, **dadurch gekennzeichnet, dass** der Heilungsstrom durch die angeschlossene Treiberschaltung erzeugt wird, indem der effektive Elektrodenwiderstand des Displays durch Parallelschaltung oder Kurzschließen von Anoden oder Kathoden verringert wird.

5. Verfahren nach einem der Ansprüche 1 bis 4 mit einem Treiber für jede Zeile oder Kathode und Spalte oder Anode des Displays, **dadurch gekennzeichnet, dass** der Strom erzeugt wird, indem ein oder mehrere der Spaltentreiber oder Anodentreiber oder Zeilentreiber oder Kathodentreiber entweder mit Erde oder Versorgungsspannung verbunden werden, womit die Potentialdifferenz an dem beeinträchtigten Pixel oder der durch dieses hindurchgehende Strom maximiert wird.

6. Verfahren nach einem der Ansprüche 1 bis 4, welches auf aktiv angesteuerte Matrixdisplays angewandt wird, indem das Potential der Analogversorgungsspannungsleitung oder von sowohl der Analogversorgungsspannungsleitung als auch der Erdungsspannungsleitung geändert oder der Einschaltwiderstand eines zur Ansteuerung eines Pixels verwendeten Halbleiterschalters durch Einstellung entsprechender Datenleitungs- und Adressenleitungsspannungen eingestellt wird.

7. Verfahren nach Anspruch 5 und 6, **dadurch gekennzeichnet, dass** die Ausgangsimpedanz von mindestens einem der Treiber oder die Ausgangsimpedanz der Analogversorgungsspannung angepasst wird.

8. Verfahren zur Verbesserung der Lebensdauer eines passiv oder aktiv angesteuerten Displays durch Anwendung der Verfahren von Anspruch 1 bis 7 zu ausgewählten Zeitpunkten.

9. Verfahren nach Anspruch 8, **dadurch gekennzeichnet, dass** der Verluststrom des Displays oder eines Teils des Displays vor Anwendung des Verfahrens nach einem der Ansprüche 1 bis 7 gemessen wird.

10. Flachbildschirm, als Organisches oder Polymer-Leuchtdioden-Display dargestellt, mit einer Vorrichtung zum Heilen von niederohmigen Fehlern in dem Display mit Mitteln zur Abgabe eines Extrastroms, welcher ein anderer Strom als dieser für den normalen Betrieb ist, um mindestens einen Fehler in einen hochohmigen Zustand zu versetzen, welcher einen höheren Widerstand als der Ausgangswiderstand des mindestens einen Fehlers aufweist, mit Steuermitteln zur Einstellung der Mittel zur Abgabe eines Extrastroms sowie mit Mitteln, um den Extrastrom während eines vorgegebenen Zeitraums durch den beeinträchtigten Teilbereich des Flachbildschirms zu leiten, **dadurch gekennzeichnet, dass** das Display und die Vorrichtung vorgesehen sind, um das Verfahren nach Anspruch 1 auszuführen.

11. Vorrichtung nach Anspruch 10, wobei die Steuermittel zur Einstellung des vorgegebenen Zeitraums vorgesehen sind.

12. Vorrichtung nach Anspruch 10, **dadurch gekennzeichnet, dass** Mittel zur Verringerung des effektiven Elektrodenwiderstands des Displays durch Parallelschaltung oder Kurzschließen von Anoden oder Kathoden vorgesehen sind.

13. Vorrichtung nach Anspruch 10 zur Verwendung mit einem Treiber für jede Zeile oder Kathode und Spalte oder Anode des Displays, **dadurch gekennzeichnet, dass** Mittel (S) vorgesehen sind, um einen oder mehrere der Spaltentreiber oder Anodentreiber oder der Zeilentreiber oder Kathodentreiber entweder mit Erde oder der Versorgungsspannung zu verbinden.

14. Vorrichtung nach Anspruch 10, **dadurch gekennzeichnet, dass** Mittel zur Änderung des Potentials der Analogversorgungsspannungsleitung oder von sowohl der Analogversorgungsspannungsleitung als auch der Erdungsspannungsleitung in einem aktiv angesteuerten Matrixdisplay vorgesehen sind.

15. Vorrichtung nach Anspruch 10, **dadurch gekennzeichnet, dass** Mittel zur Anpassung der Ausgangsimpedanz von mindestens einem der Treiber oder der Ausgangsimpedanz der Analogversorgungsspannung vorgesehen sind.

## Revendications

1. Procédé pour remédier à des défauts bas ohmiques dans un affichage plat étant un affichage à diodes électroluminescentes organiques ou polymères, **caractérisé par** le passage d'un courant supplémentaire, qui est un courant étant différent de celui d'un fonctionnement normal, pendant une période de temps prédéterminée à travers la sous-zone affectée de l'affichage plat, ledit courant étant sélectionné de manière à transformer au moins un défaut en un état haut ohmique qui présente une résistance étant supérieure à la résistance initiale dudit au moins un défaut.

2. Procédé selon la revendication 1, **caractérisé par** l'augmentation graduelle dudit courant à partir d'une valeur initiale jusqu'à une valeur maximale.

3. Procédé selon la revendication 1, **caractérisé en ce que** ladite période de temps prédéterminée est une fonction du temps de ligne ou du temps de trame dudit affichage.

4. Procédé selon la revendication 1, **caractérisé en ce que** ledit courant de rétablissement est généré par le circuit de dispositif d'attaque connecté par la diminution de la résistance d'électrode efficace de l'affichage au moyen d'une commutation parallèle ou d'un court-circuitage d'anodes ou de cathodes.

5. Procédé selon l'une quelconque des revendications précédentes 1 à 4 avec un dispositif d'attaque pour chaque ligne ou cathode et pour chaque colonne ou anode de l'affichage, **caractérisé en ce que** ledit courant est généré par la connexion d'un ou de plusieurs dispositifs d'attaque de colonne ou dispositifs d'attaque d'anode ou desdits dispositifs d'attaque de ligne ou dispositifs d'attaque de cathode soit à la masse, soit à la tension d'alimentation, ainsi maximisant la différence potentielle à travers ou le courant traversant le pixel affecté.

6. Procédé selon les revendications précédentes 1 à 4 qui est mis en oeuvre pour des affichages matriciels d'attaque active par le changement du potentiel de la ligne de tension d'alimentation analogique ou de la ligne de tension d'alimentation analogique et de masse ou par l'ajustement de la résistance d'enclenchement d'un commutateur semiconducteur qui est utilisé pour l'attaque d'un pixel au moyen de l'ajustement des tensions appropriées de ligne de données et de ligne d'adresse.

7. Procédé selon les revendications précédentes 5 et 6, **caractérisé par** l'adaptation de l'impédance de sortie d'au moins un desdits dispositifs d'attaque ou de l'impédance de sortie de la tension d'alimentation analogique.

8. Procédé d'amélioration de la durée de vie d'un affichage d'attaque passive ou active par la mise en oeuvre des procédés selon les revendications précédentes 1 à 7 à des temps sélectionnés.

9. Procédé selon la revendication 8, **caractérisé par** la mesure du courant de fuite de l'affichage ou d'une partie de l'affichage avant la mise en oeuvre du procédé selon l'une quelconque des revendications précédentes 1 à 7.

10. Affichage plat étant un affichage à diodes électroluminescentes organiques ou polymères avec un appareil pour remédier à des défauts bas ohmiques dans ledit affichage comprenant des moyens pour fournir un courant supplémentaire, qui est un courant étant différent de celui du fonctionnement normal, pour transformer au moins un défaut en un état haut ohmique qui présente une résistance étant supérieure à la résistance initiale dudit au moins un défaut,
des moyens de commande pour sélectionner lesdits moyens afin de fournir un courant supplémentaire,
et des moyens pour passer, pendant une période de temps prédéterminée, ledit courant supplémentaire à travers la sous-zone affectée de l'affichage plat,
**caractérisé en ce que** ledit affichage et ledit appareil sont agencés de manière à mettre en oeuvre le procédé selon la revendication 1.

11. Appareil selon la revendication 10, dans lequel lesdits moyens de commande sont agencés de manière à régler ladite période de temps prédéterminée.

12. Appareil selon la revendication 10, **caractérisé par** des moyens pour abaisser la résistance d'électrode efficace de l'affichage au moyen d'une commutation parallèle ou d'un court-circuitage d'anodes ou de cathodes.

13. Appareil selon la revendication 10 pour être utilisé avec un dispositif d'attaque pour chaque ligne ou cathode et pour chaque colonne ou anode de l'affichage, **caractérisé par** des moyens (S) pour connecter un ou plusieurs desdits dispositifs d'attaque de colonne ou dispositifs d'attaque d'anode ou desdits dispositifs d'attaque de ligne ou dispositifs d'attaque de cathode soit à la masse, soit à la tension d'alimentation.

14. Appareil selon la revendication 10, **caractérisé par** des moyens pour changer le potentiel de la ligne de tension d'alimentation analogique ou de la ligne de tension d'alimentation analogique et de masse dans un affichage matriciel d'attaque active.

15. Appareil selon la revendication 10, **caractérisé par** des moyens pour adapter l'impédance de sortie d'au moins un desdits dispositifs d'attaque ou l'impédance de sortie de la tension d'alimentation analogique.
